# EUROPEAN PATENT APPLICATION

(11) **EP 4 770 414 A2**
(43) Date of publication of application: **01.07.2026**
(21) Application number: 25213934.0
(22) Date of filing: 06.11.2025
(51) Int. Cl.: H10W 72/59

(54) **ISOLATORS WITH WIRE BONDS AND RELATED METHODS OF FABRICATION**

(30) Priority: 25.11.2024 US 202418958498
(71) Applicant: Analog Devices International Unlimited Company, Co. Limerick (IE)
(72) Inventor: Ravi, Adarsh, Massachusettes, 01887 (US); Zhang, Qian, Massachusetts, 01887 (US); Yun, Ruida, Massachusetts, 01887 (US); Chen, Baoxing, Massachusetts, 01887 (US); Lambkin, Paul, Limerick (IE); Lakshmanan, Ramji, Limerick (IE); Glynn, Colm, Limerick (IE); McGeehan, Rigan, Limerick (IE); Cusack, Michael J., Limerick (IE); Jolondcovschi, Stanislav, Limerick (IE); Granato, Maurizio, Limerick (IE); Bourke, Donal, Limerick (IE)
(74) Representative: Yang, Shu

(57) **Abstract**

Described herein are isolator devices designed to reduce cracking and mechanical stress despite the use of wire bonds made of hard materials (e.g., copper-based). The isolators employ thin film dielectric materials with high dielectric strength and permittivity underneath the top coil (electrode) to enhance the isolation of the device. However, these materials are susceptible to cracking. Described herein are designs in which the dielectric material is partially removed from the isolator. A dielectric layer may be kept in the region(s) where its large dielectric permittivity is particularly beneficial (e.g., near the edge of a coil) but may be removed from the region immediately underneath the bonding pad, where a large amount of pressure is applied during the bonding process. Optionally, a cushion layer is employed to absorb some of the energy produced during the bonding process.

## Description

### BACKGROUND

This patent application claims the benefit of and priority to U.S. Non-Provisional Patent Application No. 18/958,498, filed on November 25, 2024.

### Field

The present application relates to galvanic isolators.

### Related Art

Integrated galvanic isolators are semiconductor devices that provide electrical isolation between different parts of a circuit while allowing data or signals to pass between them without a direct conductive path. These devices are integrated onto a chip and are commonly used to protect sensitive components and prevent electrical noise or high voltages from crossing from one part of a system to another. Galvanic isolation refers to isolating different parts of an electrical system so that no direct current (DC) or unwanted AC can flow between them, while still allowing signal transmission. In on-chip isolators, this is achieved without physical wires or conductive paths between the isolated sides.

Integrated galvanic isolators can block high voltages, typically in the range of hundreds to tens of thousands of volts, protecting sensitive components and human operators from electrical shocks. Some isolators allow digital or analog signals to be transmitted between isolated sections of a circuit. They are designed to maintain signal integrity while protecting the circuit from high voltages, noise, or ground loops.

### BRIEF SUMMARY

Described herein are isolator devices designed to reduce cracking and mechanical stress despite the use of wire bonds made of hard materials (e.g., copper-based). The isolators employ thin film dielectric materials with high dielectric strength and permittivity underneath the top coil (electrode) to enhance the isolation of the device. However, these materials are susceptible to cracking. Described herein are designs in which the dielectric material is partially removed from the isolator. A dielectric layer may be kept in the region(s) where its large dielectric permittivity is particularly beneficial (e.g., near the edge of a coil) but may be removed from the region immediately underneath the bonding pad, where a large amount of pressure is applied during the bonding process. Optionally, a cushion layer is employed to absorb some of the energy produced during the bonding process.

Some embodiments relate to an isolator device comprising a substrate, a first conductive layer formed in the substrate, the first conductive layer defining a first conductive coil and a bonding pad; a second conductive layer formed in the substrate, the second conductive layer defining a second conductive coil; an isolation layer disposed between the first conductive layer and the second conductive layer, wherein the isolation layer is made of a first material having a first dielectric permittivity; a dielectric material layer disposed between the first conductive layer and the isolation layer, wherein the dielectric material layer is made of a second material having a second dielectric permittivity that is larger than the first dielectric permittivity, wherein the dielectric material layer defines an opening in correspondence with the bonding pad; and a bond wire attached to the bonding pad.

In some embodiments, the opening in the dielectric material layer is defined in correspondence with a central portion of the bonding pad.

In some embodiments, the opening in the dielectric material layer is defined in correspondence with an entirety of the bonding pad.

In some embodiments, the opening in the dielectric material layer is further defined in correspondence with an innermost loop of the first conductive coil.

In some embodiments, the isolator device further comprise a cushion layer made of a third material that is softer than the second material, wherein the cushion layer is disposed between the first conductive layer and the isolation layer.

In some embodiments, the cushion layer is disposed between the first conductive layer and the dielectric material layer.

In some embodiments, the bond wire is made of copper.

In some embodiments, the bond wire is made of a copper-based alloy.

In some embodiments, the first material is polyimide and the second material is silicon nitride.

In some embodiments, the first conductive layer is made of copper or a copper-based alloy.

Some embodiments relate to an isolator device, comprising a substrate, a first conductive layer formed in the substrate, the first conductive layer defining a first conductive coil and a bonding pad; a second conductive layer formed in the substrate, the second conductive layer defining a second conductive coil; an isolation layer disposed between the first conductive layer and the second conductive layer, wherein the isolation layer is made of a first material having a first dielectric permittivity; a lithographically-patterned dielectric material layer disposed between the first conductive layer and the isolation layer, wherein the lithographically-patterned dielectric material layer is made of a second material having a second dielectric permittivity that is larger than the first dielectric permittivity, wherein the lithographically-patterned dielectric material layer is defined at least in correspondence with an outermost loop of the first conductive coil and is missing in correspondence with the bonding pad; and a bond wire attached to the bonding pad.

In some embodiments, the isolator device further comprises a cushion or buffer layer made of a third material that is softer than the second material, wherein the cushion layer is disposed between the first conductive layer and the isolation layer.

In some embodiments, the cushion layer is disposed between the first conductive layer and the dielectric material layer.

In some embodiments, the lithographically-patterned dielectric material layer is missing in correspondence with a central portion of the bonding pad.

In some embodiments, the lithographically-patterned dielectric material layer is missing in correspondence with an entirety of the bonding pad.

In some embodiments, the lithographically-patterned dielectric material layer is further missing in correspondence with innermost loop of the first conductive coil.

Some embodiments relate to a method for fabricating an isolator device, comprising patterning a bottom conductive layer to define a bottom conductive coil; forming an isolation layer so as to cover the bottom conductive coil, wherein the isolation layer is made of a first material having a first dielectric permittivity; forming a dielectric material layer over the isolation layer, wherein the dielectric material layer is made of a second material having a second dielectric permittivity that is larger than the first dielectric permittivity; patterning the dielectric material layer to define an opening; patterning a top conductive layer to define a top conductive coil and a bonding pad, wherein patterning the top conductive layer comprises forming the bonding pad in correspondence with the opening in the dielectric material layer; and attaching a bond wire to the bonding pad.

In some embodiments, patterning the dielectric material layer to define the opening comprises etching the dielectric material layer using a physical etching process or a chemical etching process that could result in a vertical, sloped or rounded cross-section.

In some embodiments, the method further comprises forming a cushion layer between the first conductive layer and the isolation layer, wherein the cushion layer is made of a third material that is softer than the second material.

In some embodiments, forming the cushion layer is performed subsequent to forming the dielectric material layer.

### BRIEF DESCRIPTION OF DRAWINGS

Various aspects and embodiments of the application will be described with reference to the following figures. It should be appreciated that the figures are not necessarily drawn to scale. Items appearing in multiple figures are indicated by the same reference number in all the figures in which they appear.
FIG. 1A is a cross sectional side view of an isolator device, in accordance with some embodiments.
FIG. 1B illustrates a portion of the isolator device of FIG. 1A in additional detail, in accordance with some embodiments.
FIG. 1C is a cross sectional side view of an isolator device having an opening in the dielectric material layer with tapered edges, in accordance with some embodiments.
FIG. 1D is a cross sectional side view of an isolator device having an opening in the dielectric material layer with straight edges, in accordance with some embodiments.
FIG. 1E is a cross sectional side view of an isolator device having an opening in the dielectric material layer with curved edges, in accordance with some embodiments.
FIG. 2A is a cross sectional side view of another isolator device, in accordance with some embodiments.
FIG. 2B illustrates a portion of the isolator device of FIG. 2A in additional detail, in accordance with some embodiments.
FIG. 3 is a cross sectional side view of an isolator device having a cushion or buffer layer, in accordance with some embodiments.
FIG. 4 is a cross sectional side view of an isolator device having a ring partially surrounding the bonding pad, in accordance with some embodiments.
FIG. 5 is a cross sectional side view of a capacitive isolator employing the techniques described herein, in accordance with some embodiments.

### DETAILED DESCRIPTION

Described herein are isolator devices designed to reduce cracking and mechanical stress despite the use of wire bonds made of hard metals (e.g., copper) or hard metal alloys (e.g., copper-palladium). Wire bonding is a packaging technique used in semiconductor devices to establish electrical connections between a semiconductor die and leads or pins in the external circuitry or package. Wire bonding involves attaching fine wires (bond wires) to small bonding pads on the die. These wires are then connected to leads or pins that allow the chip to communicate with external components. Wire bonds in conventional on-chip isolators are made of soft or semi-hard materials such as aluminum or gold. The inventors propose using bond wires that are made of copper or copper-based alloys. Bond wires made of copper (or copper-based alloys) present several advantages over gold-based or aluminum-based wire bonds. First, copper is generally less expensive to procure than gold, which can reduce the overall cost of production. Second, copper has a higher conductivity than gold and aluminum. A higher conductivity in the bond wires is advantageous in that it reduces the contact's series resistance. It should be noted that the terms "bond wire" and "wire bond" are used interchangeably throughout the application.

However, the inventors have recognized and appreciated that making wire bonds in copper or copper-based alloys presents a challenge. Copper is significantly harder than gold or copper. Certain copper-based alloys are even harder. As a result, the amount of force required to attach copper-based wire bonds to bonding pads is substantially greater than the force required to attach gold-based wire bonds or aluminum-based wire bonds. The increased amount of mechanical pressure to be exerted on the chip as part of the wire attachment step can lead to mechanical stress, cracking or even permanent damage in the underlying layers. This problem is particularly severe in the presence of brittle materials deposited over a polymer, viscoelastic or semisolid material. A material is said to be brittle when it breaks or fractures easily without significant deformation or ductility, meaning that it tends to fail suddenly under stress rather than deform plastically (e.g., bend or stretch). Brittle materials typically absorb very little energy before fracture, making them prone to crack propagation.

Some isolators employ dielectric layers between a conductive coil or electrode and the underlying isolator layer to enhance the isolation of the device. These dielectric layers are characterized by a larger dielectric permittivity relative to the isolation layer, which decreases the peak electric field in the region near the coil, where the electric field tends to peak. Reducing the local peak electric field reduces the likelihood of electric breakdown, thus enhancing the isolator's working voltage range.

These dielectric layers are typically made using materials that are compatible with the existing manufacturing processes and that exhibit a high dielectric permittivity. Examples of dielectric materials that may be used to form such a material layer include silicon nitride, silicon oxynitride, aluminum oxide, boron nitride and aluminum nitride. Unfortunately, these materials are brittle. As such, application of large amounts of force when attaching copper-based bond wires to bonding pads can result in the cracking of the dielectric material layer, thus degrading the performance of the isolator, or worse, causing permanent damage. To make things worse, these dielectric materials tend to be thin (e.g., a few hundreds of nanometers), making them particularly susceptible to mechanical pressure.

Recognizing this problem, the inventors have developed designs in which the dielectric material is partially removed from the isolator. In some embodiments, a dielectric layer may be kept in the region(s) where its large dielectric permittivity is particularly beneficial (e.g., near the edge of a coil or the top electrode plate) but may be removed from the region immediately underneath the bonding pad, where a large amount of pressure is expected during the bonding process. Removal of the dielectric material may be performed for example using etching techniques (e.g., physical etching techniques or chemical etching techniques). The extent to which the dielectric material is removed depends upon various considerations, including the expected amount of pressure and the expected peak electric field. In some embodiments, the dielectric material may be removed only in the region underneath the center of the bonding pad. In other embodiments, the dielectric material may be removed from the entire region underneath the bonding pad. In yet other embodiments, the dielectric material may be removed from the entire region underneath the bonding pad and may further extent to the region underneath the inner loops of a coil.

The inventors have further developed designs in which a cushion or buffer layer is positioned underneath the bonding pad to absorb some of the energy resulting from the attachment of a bond wire. The cushion layer may be positioned above the dielectric layer, e.g., between the boding pad and the dielectric layer (although in some embodiments it may be positioned below the dielectric layer). A cushion or buffer layer may be deposited using various fabrication techniques, including spin coating, additive manufacturing techniques, physical or chemical deposition. To ensure absorption of the energy (thereby preventing cracking of the brittle dielectric layer), a cushion layer may be made using a material that is softer (with a lower hardness) than the material used for the dielectric material and/or may be made to be thicker than the dielectric layer. Having a cushion or buffer layer that is either softer or thicker (or both) than the dielectric layer results in the absorption of some the energy. It should be noted that cushion layers may be used in addition to (or in alternative to) the removal of the dielectric material from underneath the bonding pad. In one example, a cushion or buffer layer is made of titanium oxide, aluminum oxide, silicon oxynitride or silicon oxide.

It should be noted that the techniques described herein may be extended to use with wire bonds made of any suitable materials, and are not limited to use with hard metals described above. For example, these techniques may be used with wire bonds made of gold, aluminum, palladium, silver, etc.

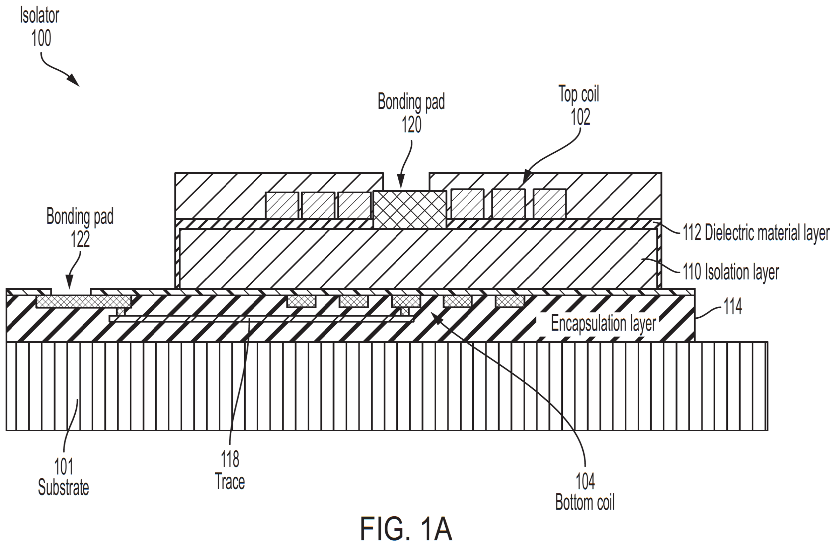

FIG. 1A is a cross sectional side view of an isolator device, in accordance with some embodiments. Isolator 100 includes a substrate 101, bottom coil 104, top coil 102, trace 118, bonding pads 120 and 122, dielectric material layer 112, isolation layer 110 and encapsulation layer 114. Coils 102 and 104 are magnetically coupled to one another, thereby forming a transformer. Top coil 102 and bonding pad 120 are defined by patterning a top conductive material layer, for example using photolithographic techniques in connection with an etching process. The top conductive material layer may be made of any suitable materials, including for example a copper-based material (e.g., copper or a copper-based alloy). Copper-based materials are advantageous over gold and aluminum because they present a higher conductivity. However, the top conductive material layer is not limited to any particular material, and may be made of gold, aluminum or other materials. In some embodiments, bonding pad 120 is defined to be surrounded by coil 102 in the plane of the conductive material layer. For example, bonding pad 120 may be positioned inside the loops defined by coil 102. Similarly, bottom coil 104 and bonding pad 122 are defined by patterning a bottom conductive material layer. The bottom conductive material layer may be made of any suitable materials, including for example a copper-based material (e.g., copper or a copper-based alloy), or other materials such as gold or aluminum.

Isolation layer 110 is disposed between top coil 102 and bottom coil 104, thereby electrically separating the coils from one another. Isolation layer 110 may be made of any suitable material that can withstand large electric fields without undergoing electric breakdown. Electric breakdown refers to the failure of an insulating material when subjected to a sufficiently high electric field. When this happens, the insulating material suddenly becomes conductive, allowing a large current to flow through it, which can lead to permanent damage or destruction of the material or the circuit it is part of. To prevent electric breakdown, isolation layer 110 may be made of a material having a relatively low dielectric permittivity and a relatively high dielectric strength. A low dielectric permittivity prevents electrical conduction while a high dielectric strength increases the point at which electric breakdown occurs. Polyimide may be used in some embodiments for isolation layer 110.

Dielectric material layer 112 is disposed between top coil 102 and isolation layer 110. Dielectric material layer 112 may be made of a material having a larger dielectric permittivity that the material with which isolation layer 110 is made. Having a larger dielectric permittivity decreases the peak electric field in the region near the coil, where the electric field tends to be the highest. Reducing the local peak electric field reduces the likelihood of electric breakdown, thus enhancing the isolator's working voltage range. Dielectric material layer 112 may be made of silicon nitride, silicon oxynitride, aluminum oxide, boron nitride or aluminum nitride. Encapsulation layer 114 encapsulates the bottom side of bottom coil 104, and may be made of silicon oxide in some embodiments.

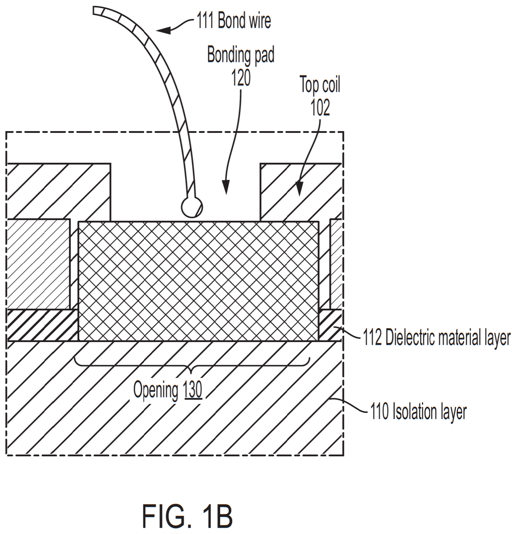

Bonding pads 120 and 122 are used for wire bonding. FIG. 1B illustrates a portion of the isolator device of FIG. 1A in additional detail, in accordance with some embodiments. As shown in FIG. 1B, a bond wire 111 is attached to bonding pad 120. A window may be formed through the top layer that encapsulates the top coil 102 to permit passage of bond wire 111. Bond wire 111 may be made of a copper-based material (e.g., copper or a copper-based alloy such as copper-palladium). As noted above, wire bonds made of copper-based materials present several advantages over gold-based or aluminum-based wire bonds. First, copper is generally less expensive to procure than gold, which can reduce the overall cost of production. Second, copper has a higher conductivity than gold or aluminum. A higher conductivity in the bond wires is advantageous in that it reduces the contact's series resistance.

As further noted above, copper is significantly harder than conventional materials used in wire bonding. As such, the amount of mechanical pressure required to attach bond wire 111 to bonding pad 120 is substantially greater than in conventional isolators. Given the brittle nature of the material with which it is made, dielectric material layer 112 may crack due to the pressure applied to attach bond wire 111 to bonding pad 120.

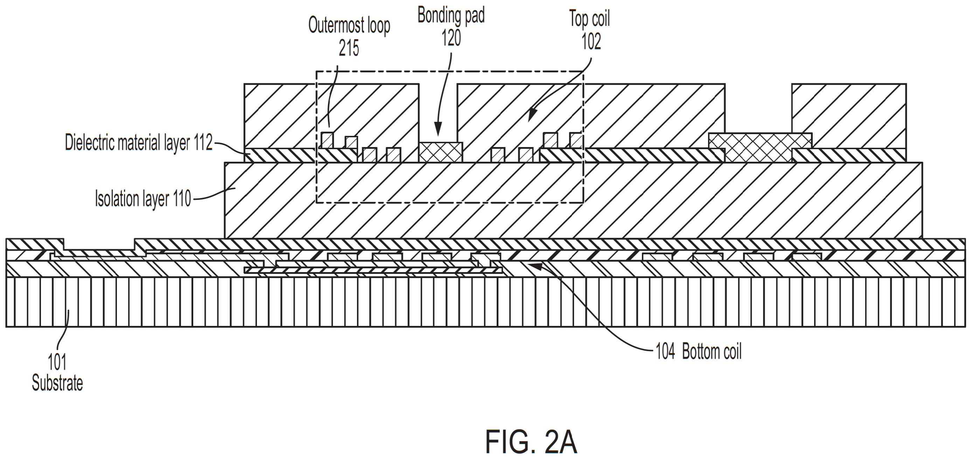

To reduce the likelihood of cracking in dielectric material layer 112, an opening 130 may be patterned through dielectric material layer 112 in correspondence with bonding pad 120, where pressure is applied to attach bond wire 111. Where opening 130 is defined, the dielectric material is missing and bonding pad 120 may be directly in contact with isolation layer 110. In the example of FIG. 1B, opening 130 is defined in correspondence with the entirety of bonding pad 120. In other words, opening 130 overlaps with bonding pad 120 and the lateral extension of opening 130 is greater than the lateral extension of bonding pad 120. Optionally, opening 130 may further defined in correspondence with an innermost loop of conductive coil 102, as described in detail below in connection with FIGs. 2A-2B. In other embodiments, opening 130 is defined in correspondence with the central portion of bonding pad 120. In other words, opening 130 overlaps with bonding pad 120 but the lateral extension of opening 130 is less than the lateral extension of bonding pad 120.

Dielectric material layer 112 may be kept in regions where a reduction in the peak electric field is likely to be beneficial from a performance standpoint and pressure from the bond wire is unlikely to negatively affect the integrity of the dielectric material layer. For example, dielectric material layer 112 may be defined in correspondence with the outermost loop of coil 102, and optionally the loops that are immediately adjacent to the outermost loop (or even all the loops in some embodiments).

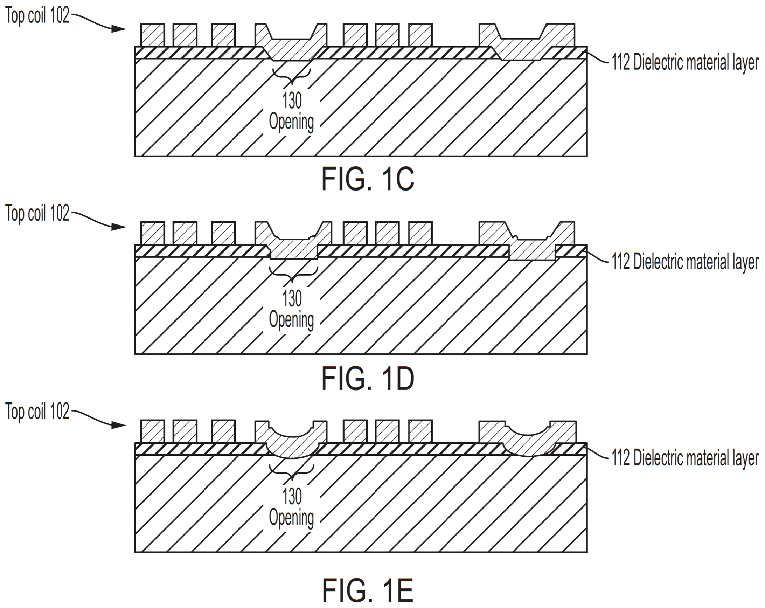

Opening 130 may be defined photolithographically using etching (e.g., physical or chemical) techniques. The profile of opening 130 may depend on the nature of the etching process. FIG. 1C is a cross sectional side view of an isolator device having an opening 130 with tapered edges. The tapered profile may be obtained using a combination of isotropic and anisotropic etching techniques. FIG. 1D is a cross sectional side view of an isolator device having an opening 130 with straight edges. The straight profile may be obtained using anisotropic etching techniques. FIG. 1E is a cross sectional side view of an isolator device having an opening 130 with curved edges. The curved profile may be obtained using isotropic etching techniques.

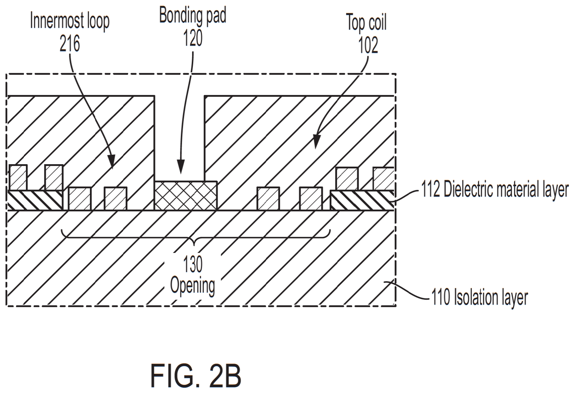

FIG. 2A is a cross sectional side view of another isolator device, in accordance with some embodiments. FIG. 2B illustrates a portion of the isolator device of FIG. 2A in additional detail. The isolator device of FIG. 2A is similar to the isolator device of FIG. 1A. However, the lateral extension of opening 130 in FIG. 2A is greater than the lateral extension of opening 130 in FIG. 1A. In the example of FIG. 2A, in addition to overlapping with bonding pad 120, opening 130 extends into the region occupied by the innermost loop 216 (FIG. 2B) of coil 102 and the loop immediately adjacent to it. As can be appreciated from FIG. 2A, dielectric material layer 112 is kept in the region corresponding to outermost loop 215 and the loop immediately adjacent to it.

**In** some embodiments, cracking in the dielectric material layer resulting from pressure applied when attaching bond wires may be mitigated using cushion or buffer layers positioned to absorb some of the energy. These cushion or buffer layers may be used in addition or in alternative to the openings in the dielectric material layer described herein. A cushion layer may be made of a material that is softer than the material used for dielectric material layer 112 and/or may be made to be thicker than dielectric material layer 112. Having a cushion layer that is either softer or thicker (or both) than the dielectric layer results in the absorption of some the energy. The material of the cushion layer is said to be softer than the material of dielectric material layer 112 in that it may have a lower hardness, which may be selected based on the Mohs scale or measured for example in units of Vickers Hardness (HV), Brinell Hardness (HB), Rockwell Hardness (HR), Knoop Hardness (HK) or using other suitable units. The buffer layers may have compatible coefficient of thermal expansion (CTE) such that they can reduce thermal mismatch stresses between the dielectric material and the underlying isolation material(s). Furthermore, these materials also help improve adhesion of the dielectric material onto the underlying viscoelastic polymer isolation material.

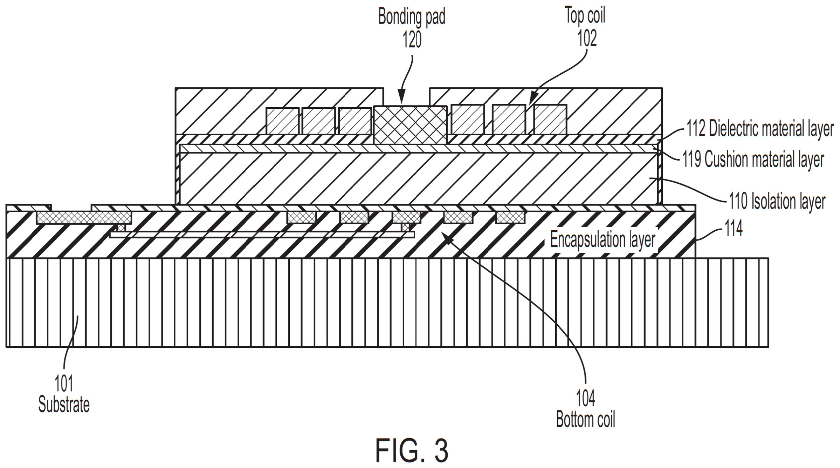

FIG. 3 is a cross sectional side view of an isolator device having a cushion layer 119, in accordance with some embodiments. In this example, cushion layer 119 is positioned between dielectric material layer 112 and isolation layer 110. In other implementations, cushion layer 119 may be positioned between dielectric material layer 112 and the conductive layer defining coil 102. Either way, cushion layer 119 may be in direct contact with dielectric material layer 112. As pressure is applied to attach bond wire 111 to a bonding pad 120, cushion layer 119 absorbs some of the energy resulting from it, thus reducing the force ultimately applied to dielectric material layer 112.

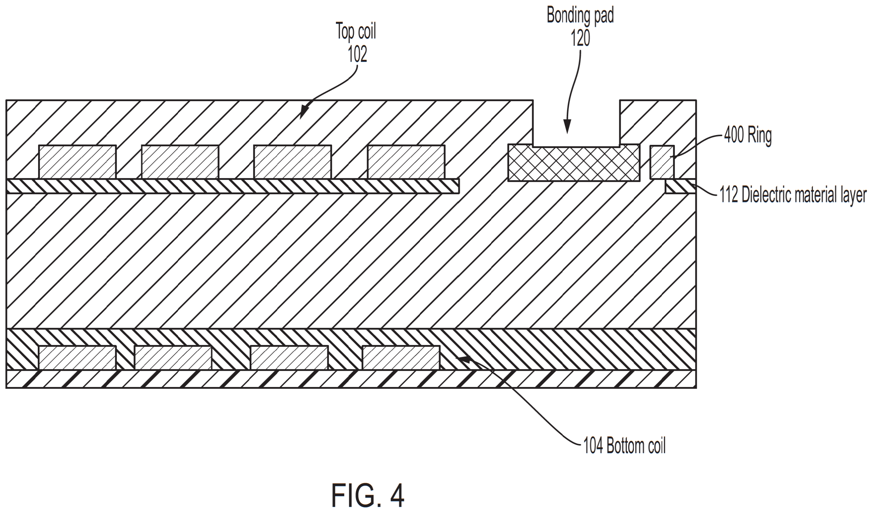

The removal or patterning of the dielectric layer around the vicinity of the coil or the bond pad could influence the electric field in the isolator. In some embodiments, to keep the peak electric field in the opening relatively low, an isolator device may include a conductive ring surrounding at least portion of a bonding pad. The presence of a conductive ring shifts the location of the peak electric field from underneath the bonding pad to underneath the ring, where it is relatively safe to keep the dielectric material layer in place. FIG. 4 is a cross sectional side view of an isolator device having a conductive ring 400 partially surrounding the bonding pad 120. In this example, conductive ring 400 is disposed between bonding pad 120 and the innermost loop of coil 102. Ring 400 may be part of the same conductive material layer defining coil 102 and bonding pad 120. Ring 400 may surround bonding pad 120 in its entirety or partially. In some embodiments, ring 400 may span an angular sector less than 360 degrees (thereby surrounding the bonding pad partially) so as to provide sufficient room to pass a conductive trace connecting bonding pad 120 to the innermost loop of coil 102. For example, ring 400 may span an angular sector between 45 degrees and 300 degrees, between 90 degrees and 300 degrees, between 180 degrees and 300 degrees, between 45 degrees and 330 degrees, between 90 degrees and 330 degrees, between 180 degrees and 330 degrees. A portion of dielectric material layer 112 may be kept in the region corresponding to ring 400 (or at least the outer portion of the ring as shown in FIG. 4), where the peak electric field is expected to be located.

Some embodiments relate to a method for fabricating an isolator device. The method comprises patterning a bottom conductive layer to define a bottom conductive coil, forming an isolation layer so as to cover the bottom conductive coil, forming a dielectric material layer over the isolation layer, patterning the dielectric material layer to define an opening, patterning a top conductive layer to define a top conductive coil and a bonding pad, and attaching a bond wire to the bonding pad. Patterning the top conductive layer comprises forming the bonding pad in correspondence with the opening in the dielectric material layer. The isolation layer is made of a first material having a first dielectric permittivity, and the dielectric material layer is made of a second material having a second dielectric permittivity that is larger than the first dielectric permittivity.

The process steps of the fabrication method may be performed in the order described above, or in any suitable order that ultimately results in any one of the isolator devices described herein. The method may further comprise forming a cushion or buffer layer between the first conductive layer and the isolation layer. The cushion layer is made of a third material that is softer than the second material.

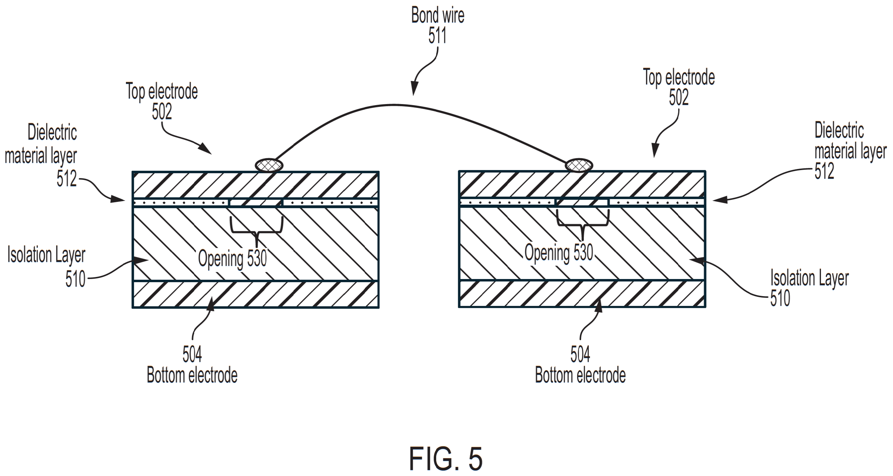

It should also be noted that the techniques described herein are not limited to coil-based isolators, but may be used in connection with other isolators as well, including but not limited to capacitive isolators connected via wire bonding. One example is depicted in FIG. 5, in accordance with some embodiments. FIG. 5 illustrates a pair of capacitive isolators connected to one another via bond wire 511. Each capacitive isolator includes a top electrode 502, a bottom electrode 504, an isolation layer 510 and a dielectric material layer 512. Isolation layer 510 and dielectric material layer 512 have the same characteristics described above in connection with isolation layer 110 and dielectric material layer 112. An opening 530 is formed through dielectric material layer 512 in correspondence with the region where bond wire 511 lands on top electrode 502. The presence of opening 530 reduces the likelihood of cracking in dielectric material layer 512.

The devices of FIG. 5 operate as capacitive isolators in that top electrode 502 and bottom electrode 504 form a pair of capacitor plates separated by a dielectric material (isolation layer 510) operating as an isolation barrier. This barrier prevents direct electrical conduction between the input and output sides. The isolator uses the electric field generated between the capacitor plates to transfer an encoded signal. Changes in the electric field correspond to changes in the transmitted signal, allowing the information to pass through the capacitor without a direct electrical connection.

Use of ordinal terms such as "first," "second," "third," etc., in the claims to modify a claim element does not by itself connote any priority, precedence, or order of one claim element over another or the temporal order in which acts of a method are performed, but are used merely as labels to distinguish one claim element having a certain name from another element having a same name (but for use of the ordinal term) to distinguish the claim elements.

Having thus described several aspects of at least one embodiment, it is to be appreciated that various alterations, modifications, and improvements will readily occur to those skilled in the art. Such alterations, modifications, and improvements are intended to be part of this disclosure and are intended to be within the spirit and scope of the principles described herein. Accordingly, the foregoing description and drawings are by way of example only.

### Numbered aspects

By way of non-limiting example, some aspects of the disclosure are set out in the following numbered clauses.
Numbered Clause 1. An isolator device, comprising:
   a substrate,
   a first conductive layer formed in the substrate, the first conductive layer defining a first conductive coil and a bonding pad;
   a second conductive layer formed in the substrate, the second conductive layer defining a second conductive coil;
   an isolation layer disposed between the first conductive layer and the second conductive layer, wherein the isolation layer is made of a first material having a first dielectric permittivity;
   a dielectric material layer disposed between the first conductive layer and the isolation layer, wherein the dielectric material layer is made of a second material having a second dielectric permittivity that is larger than the first dielectric permittivity, wherein the dielectric material layer defines an opening in correspondence with the bonding pad; and
   a bond wire attached to the bonding pad.
Numbered Clause 2. The isolator device of Numbered Clause 1, wherein the opening in the dielectric material layer is defined in correspondence with a central portion of the bonding pad.
Numbered Clause 3. The isolator device of Numbered Clause 1 or 2, wherein the opening in the dielectric material layer is defined in correspondence with an entirety of the bonding pad.
Numbered Clause 4. The isolator device of Numbered Clause 3, wherein the opening in the dielectric material layer is further defined in correspondence with an innermost loop of the first conductive coil.
Numbered Clause 5. The isolator device of any preceding Numbered Clause, further comprising a cushion layer made of a third material that is softer than the second material, wherein the cushion layer is disposed between the first conductive layer and the isolation layer.
Numbered Clause 6. The isolator device of Numbered Clause 5, wherein the cushion layer is disposed between the first conductive layer and the dielectric material layer.
Numbered Clause 7. The isolator device of any preceding Numbered Clause, wherein the bond wire is made of copper.
Numbered Clause 8. The isolator device of any of Numbered Clauses 1 to 6, wherein the bond wire is made of a copper-based alloy.
Numbered Clause 9. The isolator device of any preceding Numbered Clause, wherein the first material is polyimide and the second material is silicon nitride.
Numbered Clause 10. The isolator device of any preceding Numbered Clause, wherein the first conductive layer is made of copper or a copper-based alloy.
Numbered Clause 11. An isolator device, comprising:
   a substrate,
   a first conductive layer formed in the substrate, the first conductive layer defining a first conductive coil and a bonding pad;
   a second conductive layer formed in the substrate, the second conductive layer defining a second conductive coil;
   an isolation layer disposed between the first conductive layer and the second conductive layer, wherein the isolation layer is made of a first material having a first dielectric permittivity;
   a lithographically-patterned dielectric material layer disposed between the first conductive layer and the isolation layer, wherein the lithographically-patterned dielectric material layer is made of a second material having a second dielectric permittivity that is larger than the first dielectric permittivity, wherein the lithographically-patterned dielectric material layer is defined at least in correspondence with an outermost loop of the first conductive coil and is missing in correspondence with the bonding pad; and
   a bond wire attached to the bonding pad.
Numbered Clause 12. The isolator device of Numbered Clause 11, further comprising a cushion layer made of a third material that is softer than the second material, wherein the cushion layer is disposed between the first conductive layer and the isolation layer.
Numbered Clause 13. The isolator device of Numbered Clause 12, wherein the cushion layer is disposed between the first conductive layer and the dielectric material layer.
Numbered Clause 14. The isolator device of any of Numbered Clauses 11 to 13, wherein the lithographically-patterned dielectric material layer is missing in correspondence with a central portion of the bonding pad.
Numbered Clause 15. The isolator device of any of Numbered Clauses 11 to 14, wherein the lithographically-patterned dielectric material layer is missing in correspondence with an entirety of the bonding pad.
Numbered Clause 16. The isolator device of any of Numbered Clauses 11 to 15, wherein the lithographically-patterned dielectric material layer is further missing in correspondence with innermost loop of the first conductive coil.
Numbered Clause 17. A method for fabricating an isolator device, comprising:
   patterning a bottom conductive layer to define a bottom conductive coil;
   forming an isolation layer so as to cover the bottom conductive coil, wherein the isolation layer is made of a first material having a first dielectric permittivity;
   forming a dielectric material layer over the isolation layer, wherein the dielectric material layer is made of a second material having a second dielectric permittivity that is larger than the first dielectric permittivity;
   patterning the dielectric material layer to define an opening;
   patterning a top conductive layer to define a top conductive coil and a bonding pad, wherein patterning the top conductive layer comprises forming the bonding pad in correspondence with the opening in the dielectric material layer; and
   attaching a bond wire to the bonding pad.
Numbered Clause 18. The method of Numbered Clause 17, wherein patterning the dielectric material layer to define the opening comprises etching the dielectric material layer using a physical etching process or a chemical etching process resulting in a vertical, sloped or rounded cross-section.
Numbered Clause 19. The method of Numbered Clause 17 or 18, further comprising forming a cushion layer between the first conductive layer and the isolation layer, wherein the cushion layer is made of a third material that is softer than the second material.
Numbered Clause 20. The method of Numbered Clause 19, wherein forming the cushion layer is performed subsequent to forming the dielectric material layer.

## Claims

1. An isolator device, comprising:
a substrate,
a first conductive layer formed in the substrate, the first conductive layer defining a first conductive coil and a bonding pad;
a second conductive layer formed in the substrate, the second conductive layer defining a second conductive coil;
an isolation layer disposed between the first conductive layer and the second conductive layer, wherein the isolation layer is made of a first material having a first dielectric permittivity;
a dielectric material layer disposed between the first conductive layer and the isolation layer, wherein the dielectric material layer is made of a second material having a second dielectric permittivity that is larger than the first dielectric permittivity, wherein the dielectric material layer defines an opening in correspondence with the bonding pad; and
a bond wire attached to the bonding pad.

2. The isolator device of claim 1, wherein the opening in the dielectric material layer is defined in correspondence with a central portion of the bonding pad.

3. The isolator device of claim 1 or 2, wherein the opening in the dielectric material layer is defined in correspondence with an entirety of the bonding pad, preferably wherein the opening in the dielectric material layer is further defined in correspondence with an innermost loop of the first conductive coil.

4. The isolator device of any preceding claim, further comprising a cushion layer made of a third material that is softer than the second material, wherein the cushion layer is disposed between the first conductive layer and the isolation layer, preferably wherein the cushion layer is disposed between the first conductive layer and the dielectric material layer.

5. The isolator device of any preceding claim, wherein the bond wire is made of copper or wherein the bond wire is made of a copper-based alloy.

6. The isolator device of any preceding claim, wherein the first material is polyimide and the second material is silicon nitride.

7. The isolator device of any preceding claim, wherein the first conductive layer is made of copper or a copper-based alloy.

8. An isolator device, comprising:
a substrate,
a first conductive layer formed in the substrate, the first conductive layer defining a first conductive coil and a bonding pad;
a second conductive layer formed in the substrate, the second conductive layer defining a second conductive coil;
an isolation layer disposed between the first conductive layer and the second conductive layer, wherein the isolation layer is made of a first material having a first dielectric permittivity;
a lithographically-patterned dielectric material layer disposed between the first conductive layer and the isolation layer, wherein the lithographically-patterned dielectric material layer is made of a second material having a second dielectric permittivity that is larger than the first dielectric permittivity, wherein the lithographically-patterned dielectric material layer is defined at least in correspondence with an outermost loop of the first conductive coil and is missing in correspondence with the bonding pad; and
a bond wire attached to the bonding pad.

9. The isolator device of claim 8, further comprising a cushion layer made of a third material that is softer than the second material, wherein the cushion layer is disposed between the first conductive layer and the isolation layer, preferably wherein the cushion layer is disposed between the first conductive layer and the dielectric material layer.

10. The isolator device of claim 8 or 9, wherein the lithographically-patterned dielectric material layer is missing in correspondence with a central portion of the bonding pad.

11. The isolator device of any of claims 8 to 10, wherein the lithographically-patterned dielectric material layer is missing in correspondence with an entirety of the bonding pad.

12. The isolator device of any of claims 8 to 11, wherein the lithographically-patterned dielectric material layer is further missing in correspondence with innermost loop of the first conductive coil.

13. A method for fabricating an isolator device, comprising:
patterning a bottom conductive layer to define a bottom conductive coil;
forming an isolation layer so as to cover the bottom conductive coil, wherein the isolation layer is made of a first material having a first dielectric permittivity;
forming a dielectric material layer over the isolation layer, wherein the dielectric material layer is made of a second material having a second dielectric permittivity that is larger than the first dielectric permittivity;
patterning the dielectric material layer to define an opening;
patterning a top conductive layer to define a top conductive coil and a bonding pad, wherein patterning the top conductive layer comprises forming the bonding pad in correspondence with the opening in the dielectric material layer; and
attaching a bond wire to the bonding pad.

14. The method of claim 13, wherein patterning the dielectric material layer to define the opening comprises etching the dielectric material layer using a physical etching process or a chemical etching process resulting in a vertical, sloped or rounded cross-section.

15. The method of claim 13 or 14, further comprising forming a cushion layer between the first conductive layer and the isolation layer, wherein the cushion layer is made of a third material that is softer than the second material, preferably wherein forming the cushion layer is performed subsequent to forming the dielectric material layer.
